(19) Europäisches Patentamt
European Patent Office
Office européen des brevets

(11) **EP 2 687 906 A2**

(12) **EUROPÄISCHE PATENTANMELDUNG**

(43) Veröffentlichungstag:
**22.01.2014 Patentblatt 2014/04**

(51) Int Cl.:
***G03F 7/20*** *(2006.01)*

(21) Anmeldenummer: **13193958.9**

(22) Anmeldetag: **21.11.2013**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **25.06.2013 DE 102013212109**

(71) Anmelder: **Carl Zeiss SMT GmbH
73447 Oberkochen (DE)**

(72) Erfinder: **Horn, Jan
80639 München (DE)**

(74) Vertreter: **Carl Zeiss AG - Patentabteilung
Carl-Zeiss-Strasse 22
73447 Oberkochen (DE)**

(54) **Einrichtung und Verfahren zur Steuerung der Positionierung eines verlagerbaren Einzelspiegels**

(57) Bei einer Steuereinrichtung (27) zur Steuerung der Positionierung mindestens eines verlagerbaren Einzelspiegels (23) dient mindestens eine Aktuatorelektrode (24) auch als Sensorelektrode (34). Die Ansteuerung der Einzelspiegel (23) erfolgt über ein Pulsweitenmodulationsschema.

Fig. 10

EP 2 687 906 A2

**Beschreibung**

Die Erfindung betrifft eine Einrichtung zur Steuerung der Positionierung mindestens eines verlagerbaren Einzelspiegels. Die Erfindung betrifft weiterhin eine optische Baugruppe mit einer derartigen Steuereinrichtung. Außerdem betrifft die Erfindung eine Beleuchtungsoptik, ein Beleuchtungssystem und eine Projektionsbelichtungsanlage mit einer derartigen optischen Baugruppe. Weiterhin betrifft die Erfindung ein Verfahren zur Steuerung der Positionierung eines Einzelspiegels. Schließlich betrifft die Erfindung ein Verfahren zur Herstellung eines mikro- oder nanostrukturierten Bauelements.

Optische Bauelemente mit verlagerbaren Spiegeln ermöglichen eine sehr flexible Führung optischer Strahlung. Ein optisches Bauelement mit verlagerbaren Einzelspiegeln ist beispielsweise aus der WO 2010/049 076 A2 bekannt. Ein entsprechendes Bauelement und eine Steuereinrichtung zur Positionierung der Einzelspiegel ist auch aus der DE 10 2012 202 501.4 und der DE 10 2012 218 219.5 bekannt.

Eine Aufgabe der Erfindung besteht darin, eine Steuereinrichtung zur Positionierung eines verlagerbaren Einzelspiegels zu verbessern.

Diese Aufgabe wird erfindungsgemäß durch eine Steuereinrichtung gelöst mit einer Aktuator-Einrichtung und einer Sensor-Einrichtung, wobei mindestens eine Aktuator-Elektrode auch als Sensor-Elektrode dient, und wobei die Ansteuerung der Einzelspiegel über eine Pulsweitenmodulation erfolgt.

Hierdurch wird die Ansteuerung des Einzelspiegels vereinfacht und verbessert. Außerdem führt dies zu einer Verringerung des konstruktiven Aufwands der Steuereinrichtung. Alle nachfolgend aufgeführten Aspekte der Erfindung ordnen sich der oben formulierten Erfindung unter. Insbesondere enthalten alle erfindungsgemäßen Gegenstände eine Steuereinrichtung mit einer Aktuator-Einrichtung und einer Sensor-Einrichtung, wobei mindestens eine Aktuator-Elektrode auch als Sensor-Elektrode dient, und wobei die Ansteuerung der Einzelspiegel über eine Pulsweitenmodulation erfolgt.

Gemäß einem Aspekt der Erfindung ist zur Steuerung mehrerer Elektroden eine gemeinsame analoge Schaltung vorgesehen.

Die analoge Schaltung kann jeweils mit einem digitalen Steuerkreis verbunden sein.

Gemäß einem weiteten Aspekt der Erfindung beträgt das Tastverhältnis zwischen Aktuierungs- und Messdauer mindestens 1 : 1, insbesondere mindestens 10 : 1, insbesondere mindestens 100 : 1, insbesondere mindestens 1000 : 1.

Gemäß einem weiteren Aspekt der Erfindung ist je Einzelspiegel eine einzige, insbesondere maximal eine einzige Hochspannungs-Endstufe vorgesehen. Hierdurch wird der konstruktive Aufbau der Steuereinrichtung vereinfacht.

Gemäß einem weiteren Aspekt der Erfindung ist eine gemeinsame Hochspannungs-Endstufe für sämtliche Einzelspiegel in einem Einzelspiegel-Array vorgesehen.

Hierdurch wird der konstruktive Aufwand der Steuereinrichtung weiter vereinfacht.

Eine weitere Aufgabe der Erfindung besteht darin, eine optische Baugruppe zu verbessern.

Diese Aufgabe wird durch eine optische Baugruppe mit einer Vielzahl von verlagerbaren Einzelspiegeln und einer erfindungsgemäßen Steuereinrichtung gelöst.

Die Vorteile entsprechen den vorhergehend beschriebenen.

Weitere Aufgaben der Erfindung bestehen darin, eine Beleuchtungsoptik und ein Beleuchtungssystem für eine Projektionsbelichtungsanlage für die Mikrolithografie, insbesondere für eine EUV-Projektionsbelichtungsanlage, und eine derartige Projektionsbelichtungsanlage zu verbessern.

Diese Aufgaben werden durch eine Beleuchtungsoptik, ein Beleuchtungssystem und eine Projektionsbelichtungsanlage mit einer erfindungsgemäßen Baugruppe gelöst.

Die Vorteile ergeben sich aus den vorhergehend beschriebenen.

Eine weitere Aufgabe der Erfindung besteht darin, ein Verfahren zur Steuerung der Positionierung von Einzelspiegeln einer optischen Baugruppe zu verbessern.

Diese Aufgabe wird durch ein Verfahren mit einem Mess- und Aktuierungszyklus mit aufeinanderfolgenden Mess- und Aktuierungs-Schritten gelöst, wobei die Ansteuerung der Einzelspiegel über ein Pulsweitenmodulationsschema erfolgt.

Gemäß einem Aspekt der Erfindung weist der Mess- und Aktuierungszyklus eine Zyklusdauer auf, welche kürzer ist als die Zeitkonstante entsprechend der Regelbandbreite der Steuereinrichtung und/oder die kürzeste mechanische Zeitkonstante des Einzelspiegels.

Eine weitere Aufgabe der Erfindung besteht darin, ein Verfahren zur Herstellung eines mikro- oder nanostrukturierten Bauelements zu verbessern.

Diese Aufgabe wird durch ein Verfahren gelöst, bei welchem ein Retikel mit abzubildenden Strukturen mit Hilfe einer erfindungsgemäßen Projektionsbelichtungsanlage auf ein  Substrat mit einer lichtempfindlichen Schicht projiziert wird. Die Vorteile ergeben sich aus denen der Projektionsbelichtungsanlage.

Weitere Details und Vorteile der Erfindung ergeben sich aus der Beschreibung mehrerer Ausführungsbeispiele anhand der Zeichnungen.

Es zeigen:

Fig. 1      eine schematische Darstellung einer Projektionsbelichtungsanlage für die Mikrolithografie in einem Meridionalschnitt,

Fig. 2      einen schematischen Querschnitt durch einen Ausschnitt eines optischen Bauelements gemäß einer ersten Ausführungsform,

Fig. 3      einen schematischen Querschnitt durch einen Ausschnitt eines optischen Bauelements gemäß einer weiteren Ausführungsform,

Fig. 4 und Fig. 5      schematische Darstellungen weiterer Ausführungsbeispiele des optischen Bauelements,

Fig. 6      eine schematische Darstellung einer Mess- und Ansteuerschaltung zur Steuerung der Positionierung von Einzelspiegeln,

Fig. 7      eine Ausschnittsvergrößerung des analogen Teils der Schaltung gemäß Fig. 6,

Fig. 8      schematisch eine weitere Schaltung zur Steuerung der Positionierung von Einzelspiegeln,

Fig. 9      schematisch eine exemplarische Darstellung der Anbindung der Schaltung gemäß Fig. 8 an einen Einzelspiegel und

Fig. 10      schematisch eine exemplarische Darstellung der zeitlichen Abfolge des Steuerverfahrens mit Hilfe der Schaltung gemäß Fig. 8.

Im Folgenden wird zunächst der prinzipielle Aufbau einer Projektionsbelichtungsanlage 1 anhand der Figuren beschrieben. Diesbezüglich sei auf die DE 10 2012 202 501.4 und die DE 10 2012 218 219.5 verwiesen, die hiermit als Bestandteil der vorliegenden Anmeldung vollständig in diese integriert sein sollen.

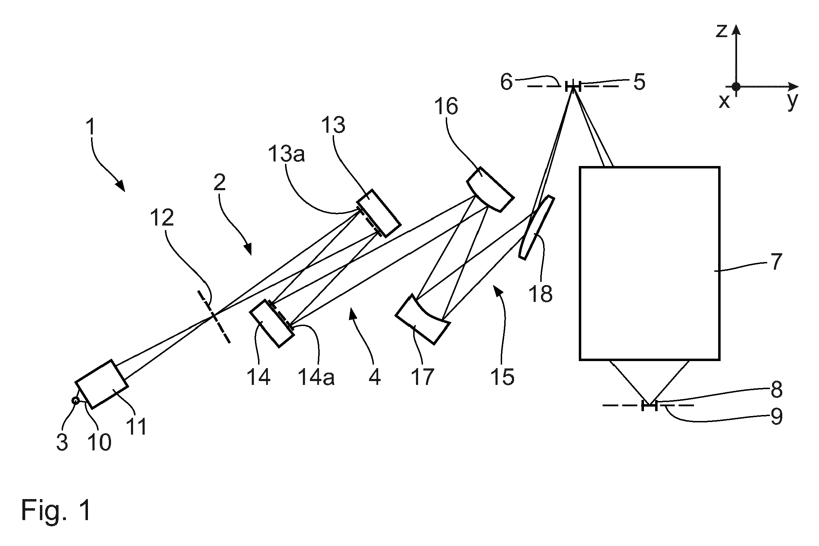

Fig. 1 zeigt schematisch in einem Meridionalschnitt eine Projektionsbelichtungsanlage 1 für die Mikrolithografie. Ein Beleuchtungssystem 2 der Projektionsbelichtungsanlage 1 hat neben einer Strahlungsquelle 3 eine Beleuchtungsoptik 4 zur Belichtung eines Objektfeldes 5 in einer Objektebene 6. Das Objektfeld 5 kann rechteckig oder bogenförmig mit einem x/y-Aspektverhältnis von beispielsweise 13/1 gestaltet sein. Belichtet wird hierbei ein im Objektfeld 5 angeordnetes und in der Fig. 1 nicht dargestelltes reflektierendes Retikel, das eine mit der Projektionsbelichtungsanlage 1 zur Herstellung mikrobeziehungsweise nanostrukturierter Halbleiter-Bauelemente zu projizierende Struktur trägt. Eine Projektionsoptik 7 dient zur Abbildung des Objektfeldes 5 in ein Bildfeld 8 in einer Bildebene 9. Abgebildet wird die Struktur auf dem Retikel auf eine lichtempfindliche Schicht eines im Bereich des Bildfeldes 8 in der Bildebene 9 angeordneten Wafers, der in der Zeichnung nicht dargestellt ist.

Das Retikel, das von einem nicht dargestellten Retikelhalter gehalten ist, und der Wafer, der von einem nicht dargestellten Waferhalter gehalten ist, werden beim Betrieb der Projektionsbelichtungsanlage 1 synchron in der y-Richtung gescannt. Abhängig vom Abbildungsmaßstab der Projektionsoptik 7 kann auch ein gegenläufiges Scannen des Retikels relativ zum Wafer stattfinden.

Mit Hilfe der Projektionsbelichtungsanlage 1 wird wenigstens ein Teil des Retikels auf einen Bereich einer lichtempfindlichen Schicht auf dem Wafer zur lithographischen Herstellung eines mikro- beziehungsweise nanostrukturierten Bauelements, insbesondere eines Halbleiterbauelements, zum Beispiel eines Mikrochips abgebildet. Je nach Ausführung der Projektionsbelichtungsanlage 1 als Scanner oder als Stepper werden das Retikel und der Wafer zeitlich synchronisiert in der y-Richtung kontinuierlich im Scannerbetrieb oder schrittweise im Stepperbetrieb verfahren.

Bei der Strahlungsquelle 3 handelt es sich um eine EUV-Strahlungsquelle mit einer emittierten Nutzstrahlung im Bereich zwischen 5 nm und 30 nm. Es kann sich dabei um eine Plasmaquelle, beispielsweise um eine GDPP-Quelle (Plasmaerzeugung durch Gasentladung, Gas Discharge Produced Plasma), oder um eine LPP-Quelle (Plasmaerzeugung durch Laser, Laser Produced Plasma) handeln. Auch andere EUV-Strahlungsquellen, beispielsweise solche, die auf einem Synchrotron oder auf einem Free Electron Laser (Freie Elektronenlaser, FEL) basieren, sind möglich.

EUV-Strahlung 10, die von der Strahlungsquelle 3 ausgeht, wird von einem Kollektor 11 gebündelt. Ein entsprechender Kollektor ist beispielsweise aus der EP 1 225 481 A bekannt. Nach dem Kollektor 11 propagiert die EUV-Strahlung 10 durch eine Zwischenfokusebene 12, bevor sie auf einen Feldfacettenspiegel 13 mit einer Vielzahl von Feldfacetten 13a trifft. Der Feldfacettenspiegel 13 ist in einer Ebene der Beleuchtungsoptik 4 angeordnet, die zur Objektebene 6 optisch konjugiert ist.

Die EUV-Strahlung 10 wird nachfolgend auch als Nutzstrahlung, Beleuchtungslicht oder als Abbildungslicht bezeichnet.

Nach dem Feldfacettenspiegel 13 wird die EUV-Strahlung 10 von einem Pupillenfacettenspiegel 14 mit einer Vielzahl von Pupillenfacetten 14a reflektiert. Der Pupillenfacettenspiegel 14 liegt entweder in der Eintrittspupillenebene der Beleuchtungsoptik 7 oder in einer hierzu optisch konjugierten Ebene. Der Feldfacettenspiegel 13 und der Pupillenfacettenspiegel 14 sind aus einer Vielzahl von Einzelspiegeln 23 aufgebaut, die nachfolgend noch näher beschrieben werden. Dabei kann die Unterteilung des Feldfacettenspiegels 13 in Einzelspiegel 23 derart sein, dass jede der Feldfacetten 13a, die für sich das gesamte Objektfeld 5 ausleuchten, durch genau einen der Einzelspiegel 23 repräsentiert wird. Alternativ ist es möglich, zumindest einige oder alle der Feldfacetten 13a durch eine Mehrzahl derartiger Einzelspiegel 23 aufzubauen. Entsprechendes gilt für die Ausgestaltung der den Feldfacetten 13a jeweils zugeordneten Pupillenfacetten 14a des Pupillenfacettenspiegels 14, die jeweils durch einen einzigen Einzelspiegel 23 oder durch eine Mehrzahl derartiger Einzelspiegel 23 gebildet sein können.

Die EUV-Strahlung 10 trifft auf die beiden Facettenspiegel 13, 14 unter einem Einfallswinkel, gemessen normal zur Spiegelfläche, auf, der kleiner oder gleich 25° ist. Die beiden Facettenspiegel 13, 14 werden also im Bereich eines normal incidence-Betriebs mit der EUV-Strahlung 10 beaufschlagt. Auch eine Beaufschlagung unter streifendem Einfall (grazing incidence) ist möglich. Der Pupillenfacettenspiegel 14 ist in einer Ebene der Beleuchtungsoptik 4 angeordnet, die eine Pupillenebene der Projektionsoptik 7 darstellt beziehungsweise zu einer Pupillenebene der Projektionsoptik 7 optisch konjugiert ist. Mithilfe des Pupillenfacettenspiegels 14 und einer abbildenden optischen Baugruppe in Form einer Übertragungsoptik 15 mit in der Reihenfolge des Strahlengangs für die EUV-Strahlung 10 bezeichneten Spiegeln 16, 17 und 18 werden die Feldfacetten 13a des Feldfacettenspiegels 13 einander überlagernd in das Objektfeld 5 abgebildet. Der letzte Spiegel 18 der Übertragungsoptik 15 ist ein Spiegel für streifenden Einfall ("Grazing incidence Spiegel"). Die Übertragungsoptik 15 wird zusammen mit dem Pupillenfacettenspiegel 14 auch als Folgeoptik zur Überführung der EUV-Strahlung 10 vom Feldfacettenspiegel 13 hin zum Objektfeld 5 bezeichnet. Das Beleuchtungslicht 10 wird von der Strahlungsquelle 3 hin zum Objektfeld 5 über eine Mehrzahl von Ausleuchtungskanälen geführt. Jedem dieser Ausleuchtungskanäle ist eine Feldfacette 13a des Feldfacettenspiegels 13 und eine dieser nachgeordnete Pupillenfacette 14a des Pupillenfacettenspiegels 14 zugeordnet. Die Einzelspiegel 23 des Feldfacettenspiegels 13 und des Pupillenfacettenspiegels 14 können aktuatorisch verkippbar sein, sodass ein Wechsel der Zuordnung der Pupillenfacetten 14a zu den Feldfacetten 13a und entsprechend eine geänderte Konfiguration der Ausleuchtungskanäle erreicht werden kann.

Die Spiegelelemente 23 der Beleuchtungsoptik 4 sind vorzugsweise in einer evakuierbaren Kammer angeordnet. Sie sind mechanisch weitestgehend ungedämpft, so dass sie sehr empfindlich auf Störungen durch Vibrationen reagieren.

Im Folgenden wird der Aufbau des Feldfacettenspiegels 13, insbesondere der Einzelspiegel 23 desselben näher beschrieben. Die Erfindung ist jedoch nicht hierauf beschränkt. Allgemein sind die Einzelspiegel 23 Bestandteile eines optischen Bauelements 25.

Die Einzelspiegel 23 werden im Folgenden auch als Spiegelelemente 23 bezeichnet. Sie sind aktuatorisch verkippbar ausgelegt, wie nachfolgend noch erläutert wird. Insgesamt weist der Feldfacetten-Spiegel 13 mindestens 300, insbesondere mindestens 1000, insbesondere mindestens 10000, insbesondere mindestens 100000 Einzelspiegel 23 auf.

Bei den Spiegelelementen 23 kann es sich insbesondere um sogenannte Mikrospiegel handeln. Sie weisen insbesondere Abmessungen im Bereich von $10^{-8}$ m$^2$ bis $10^{-4}$ m$^2$, insbesondere im Bereich von $10^{-7}$ m$^2$ bis $10^{-5}$ m$^2$ auf. Prinzipiell kann es sich auch um makroskopische Spiegel mit größeren Abmessungen handeln.

Die Spiegelelemente 23 sind auf einer ersten Tragestruktur 19 angeordnet. Diese ist über einen Wärmeleitungsabschnitt mit einem Spiegelkörper 20 eines der Spiegelelemente 23 mechanisch verbunden. Teil des Wärmeleitungsabschnitts ist ein Gelenkkörper 21, der eine Verkippung des Spiegelkörpers 20 relativ zur ersten Tragestruktur 19 zulässt. Der Gelenkkörper 21 kann als Festkörpergelenk ausgebildet sein, das eine Verkippung des Spiegelkörpers 20 um definierte Kippachsen, beispielsweise um eine oder zwei, insbesondere senkrecht zueinander angeordnete, Kippachsen zulässt. Für Details der verkippbaren Anordnung der Spiegelelemente 23, insbesondere deren Anordnung in der ersten Tragestruktur 19, sei auf die DE 10 2011 006 100.2 und die DE 10 2012 202 501.4 verwiesen, die hiermit vollständig Bestandteil der vorliegenden Anmeldung sein soll.

Das Spiegelelement 23 ist jeweils mechanisch mit einem Aktuatorstift 22 verbunden. Der Aktuatorstift 22 bildet eine mechanisch mit dem Spiegel verbundene Elektrode, welche im Folgenden auch als Spiegelelektrode bezeichnet wird.

Die erste Tragestruktur 19 bildet jeweils eine den Aktuatorstift 22 umgebende Hülse. In der Hülse sind jeweils Aktuatorelektroden 24 integriert. Es ist jeweils mindestens eine Aktuatorelektrode 24 je Kippfreiheitsgrad vorgesehen. Vorzugsweise sind jeweils zwei Aktuatorelektroden 24 je Kippfreiheitsgrad vorgesehen. Es können auch drei Aktuatorelektroden 24 zur Verkippung des Spiegelelements 23 mit zwei Kippfreiheitsgraden vorgesehen sein. Die drei Aktuatorelektroden 24 sind vorzugsweise in Umfangsrichtung jeweils um 120° gegeneinander versetzt angeordnet. Eine hiervon abweichende Anordnung ist ebenso möglich.

Durch Erzeugen einer Potentialdifferenz zwischen einer oder mehrerer der Aktuatorelektroden 24 und dem Aktuatorstift 22 lässt sich eine elektrostatische Kraft auf den Aktuatorstift 22 erzeugen, welche zu einer Verkippung des Spiegelelements 23 führen kann. Allgemein werden die Aktuatorelektroden 24 zur Verkippung des Spiegelelements 23 mit einer Aktuatorspannung $V_{Akt}$ beaufschlagt.

Die Spiegelelemente 23 sind vorzugsweise matrixartig in einem sogenannten Spiegelarray angeordnet.

Das optische Bauelement 25 umfasst neben den in der ersten Tragestruktur 19 angeordneten Spiegelelementen 23 eine zweite Tragestruktur 26. Die zweite Tragestruktur 26 ist versetzt zu den Spiegelelementen 23 angeordnet. Die weist insbesondere einen Querschnitt auf, welcher zu den der ersten Tragestruktur 19 identisch ist. Die zweite Tragestruktur 26 dient der Anordnung und/oder Aufnahme weiterer funktioneller Bestandteile, insbesondere einer Steuereinrichtung 27 zur Steuerung der Verlagerung der Spiegelelemente 23. Die Steuereinrichtung 27 umfasst insbesondere eine als anwendungsspezifische integrierte Schaltung 28 (englisch: application specific integrated circuit, ASIC). Die Steuereinrichtung 27 kann auch in den ASIC 28 integriert sein.

Die Steuereinrichtung 27 umfasst eine Sensoreinrichtung 38 mit mindestens einer, vorzugsweise mindestens zwei Sensorelektroden 34. Die Sensorelektroden 34 können auf dem ASIC 28 angeordnet sein. Es sind insbesondere jeweils mindestens zwei Sensorelektroden 34 je Kippfreiheitsgrad vorgesehen. Die Sensorelektroden 34 können insbesondere differenziell verschaltet sein. Eine andere Anzahl von Sensorelektroden 34 ist ebenso möglich. Vorteilhafterweise ist zu jeder Aktuatorelektrode 24 eine entsprechende Sensorelektrode 34 vorgesehen. Die Sensorelektroden 34 sind Teil eines kapazitiven Sensors. Vorzugsweise können die Aktuatorelektroden 24 jeweils auch als Sensorelektroden 34 genutzt werden. Die Aktuatorelektroden 24 können mit anderen Worten gleichzeitig Sensorelektroden 34 bilden.

Allgemein umfasst die Sensoreinrichtung 38 ein Mittel, insbesondere einen Schaltkreis, zur Erfassung einer Kapazitätsänderung. Die Sensoreinrichtung 38 umfasst insbesondere einen oder mehrere elektronische Schaltkreise zur Auswertung der Signale von den Sensorelektroden 34. Derartige Schaltkreise sind vorzugsweise in das ASIC 28 integriert.

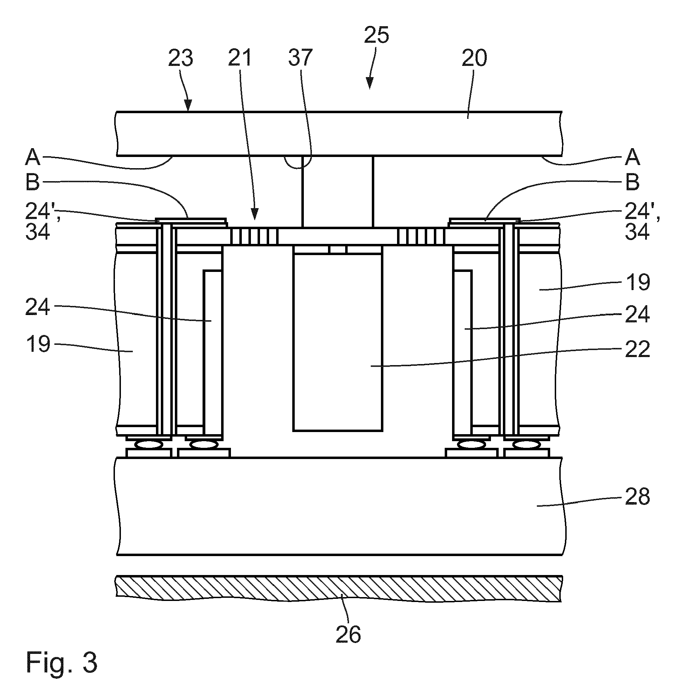

Bei dem in Fig. 3 dargestellten Ausführungsbeispiel ist die Spiegelelektrode 37 durch den Spiegelkörper 20 selbst gebildet. Dieser bildet somit die bewegliche Elektrode der lokalen Sensoreinrichtung 38. Hierbei sind die starren Sensorelektroden 34 auf der dem Spiegelelement 23 zugewandten Seite der ersten Tragestruktur 19 angeordnet. Sie sind somit direkt unterhalb des Spiegelkörpers 20 des Spiegelelements 23 angeordnet.

Im Folgenden wird die Funktionsweise der lokalen Regelung näher beschrieben. Wie bereits beschreiben, lässt sich das Spiegelelement 23 durch Anlegen einer Spannung zwischen den Aktuatorelektroden 24 und der Spiegelelektrode 37 verkippen. Entsprechend ändert sich bei einer Verkippung des Spiegelelements 23 die Kapazität zwischen der Sensorelektrode 34 und der Spiegelelektrode 37. Derartige Kapazitätsänderungen lassen sich mittels der Sensorelektroden 34 erfassen. Aus der Amplitude des gemessenen Signals kann dann ein Rückkopplungssignal zur Regelung der Verkippung des Spiegelelements 23 ermittelt werden.

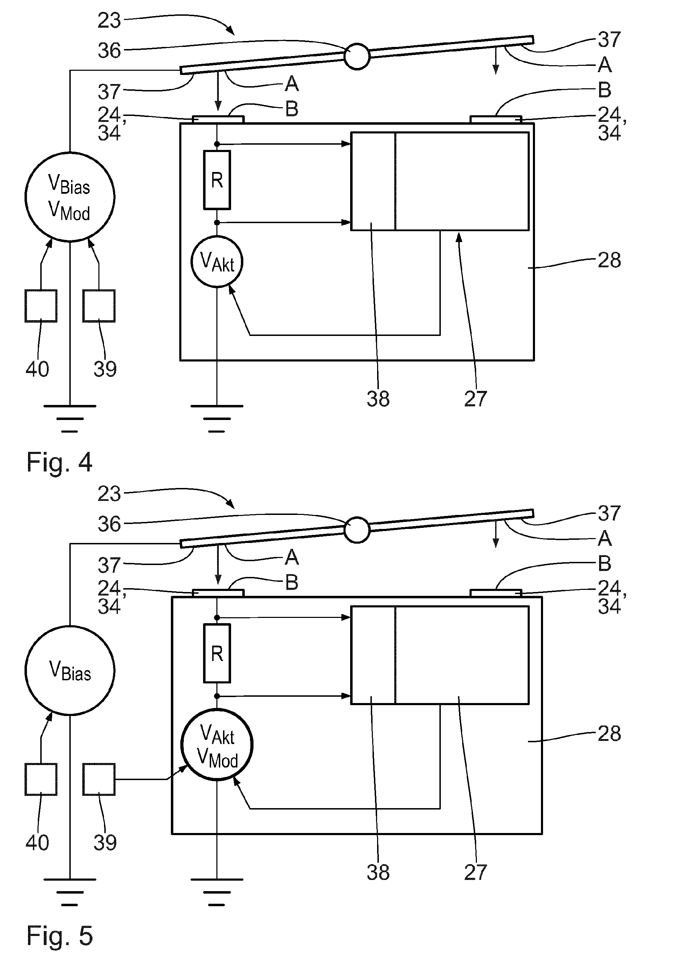

Als beispielhafte Realisierung für die Auswertung der Kapazitätsänderung ist in den Figuren 4 und 5 jeweils die Auswertung mit einem RC-Glied dargestellt. Hierbei ist der Spannungsabfall über dem Widerstand R abhängig von der Kapazität zwischen der Sensorelektrode 34 und dem Spiegel 23, das heißt der Spiegelelektrode 37. Da Widerstände zumeist viel ASIC-Chipfläche benötigen, kann auch ein Spannungsteiler, welcher nur aus Kondensatoren besteht, verwendet werden. Alternativ kann auch direkt eine Strommessung durch den Kondensator erfolgen, beispielsweise durch einen Strom/SpannungsVerstärker.

Zur Ermittlung eines Rückkopplungssignals wird das mittels der Sensoreinrichtung 38 gemessene Signal gleichgerichtet. Hierzu ist insbesondere ein Gleichrichter in Form einer Diode vorgesehen. Dies ermöglicht eine Realisierung mit einem geringen Bedarf an Chipfläche.

Alternative Möglichkeiten zur Messung der Kapazitätsänderungen sind denkbar. Beispielsweise können auch Spannungsabfälle gemessen werden, wenn die Sensorelektroden 34 beispielsweise jeweils in einem RC-Glied verschaltet sind. Auch eine Phasenmessung des sinusförmigen Spannungsabfalls an einem RC-Glied ist denkbar.

Zur Regelung der Verkippung des Spiegelelements 23 wird die Aktuatorelektrode 24 mittels der Steuereinrichtung 27 mit dem Rückkopplungssignal beaufschlagt. Das Rückkopplungssignal kann auch mehreren Aktuatorelektroden 24 zugeführt werden.

In den in den Figuren 4 und 5 dargestellten Ausführungsformen dienen die Aktuatorelektroden 24 gleichzeitig als Sensorelektroden 34. Auf konstruktiv separate Sensorelektroden kann in diesem Fall verzichtet werden.

Vorhergehend wurde die Regelung der Verkippung des Spiegelelements 23 lediglich in Bezug auf eine Kippachse beschrieben. Selbstverständlich sind dieselben Prinzipien auf andere Designs, beispielsweise mit drei Aktuatorelektroden 24 und zwei Kippachsen, übertragbar.

Die erfindungsgemäße Regelung der Verkippung der Spiegelelemente 23 ist besonders für optische Bauelemente 25 mit einer großen Anzahl Einzelspiegel 23 vorteilhaft. Sie ist jedoch entsprechend auch auf makroskopische Einzelspiegel 23 anwendbar.

Beim Einsatz der Projektionsbelichtungsanlage 1 werden ein Retikel und der Wafer, der eine für das Beleuchtungslicht 10 lichtempfindliche Beschichtung trägt, bereitgestellt. Anschließend wird zumindest ein Abschnitt des Retikels mit Hilfe der Projektionsbelichtungsanlage 1 auf den Wafer projiziert. Bei der Projektion des Retikels auf den Wafer kann der Retikelhalter und/oder der Waferhalter in Richtung parallel zur Objektebene 6 bzw. parallel zur Bildebene 9 verlagert werden. Die Verlagerung des Retikels und des Wafers kann vorzugsweise synchron zueinander erfolgen. Schließlich wird die mit dem Beleuchtungslicht 10 belichtete lichtempfindliche Schicht auf dem Wafer entwickelt. Auf diese Weise wird ein mikro- beziehungsweise nanostrukturiertes Bauelement, insbesondere ein Halbleiterchip, hergestellt.

Im Folgenden werden weitere Details der Steuereinrichtung 27 beschrieben. Wie bei der DE 10 2012 218 219.5 ist es vorteilhaft, die Steuereinrichtung 27 derart auszubilden, dass mindestens eine der Aktuatorelektroden 24 auch als Sensorelektrode 34 dient. Grundidee und wesentliches Merkmal der vorliegenden Erfindung ist es, zur Ansteuerung der Aktuatorelektroden ein Pulsweitenmodulationsschema (PWM-Schema) zu verwenden.

Da die Steuereinrichtung 27 sowohl die Aktuatorelektrode 24 zur Aktuierung des Einzelspiegels 23 als auch die Sensorelektrode 34 zur Positionsmessung, insbesondere zur Erfassung des Kippwinkels desselben umfasst, ermöglicht die Steuereinrichtung 27 eine Kippwinkelregelung, insbesondere eine sogenannte Closed Loop Regelung. Sie ermöglicht eine Regelung mit einer hohen Bandbreite. Sie ist vorteilhafterweise in deren ASIC 28 realisiert.

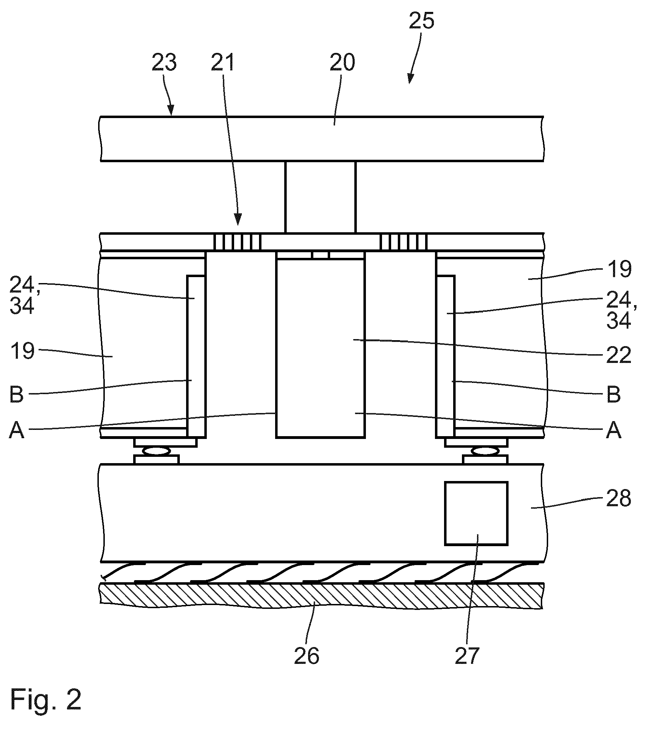

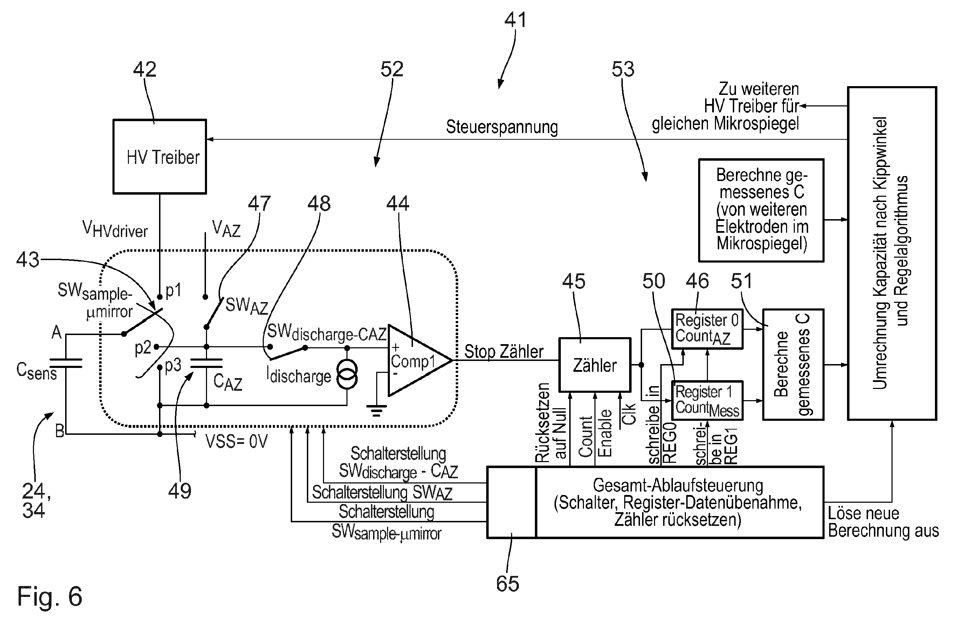

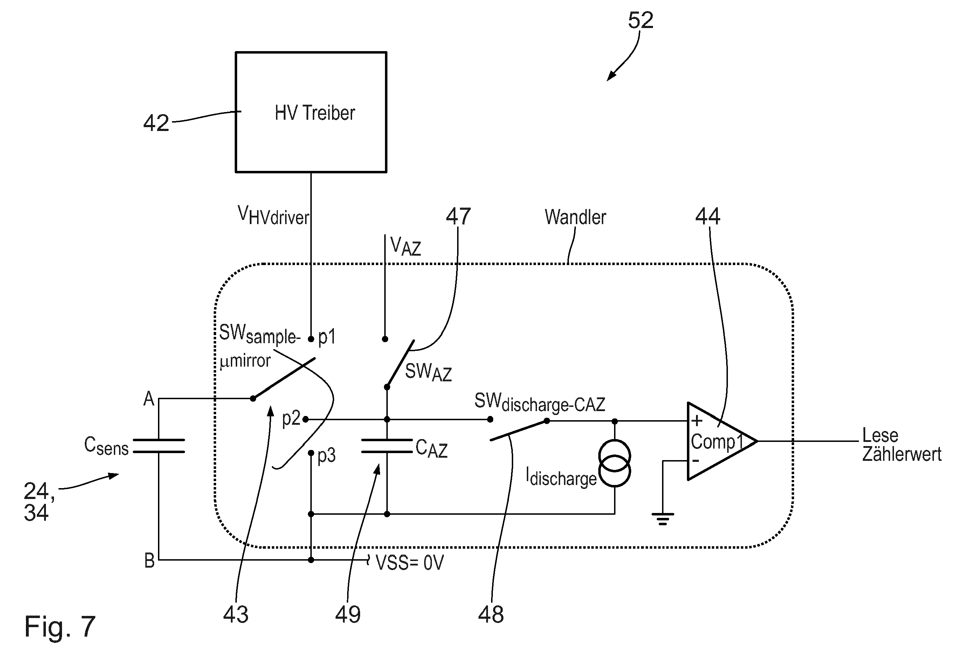

In den Figuren 6 und 7 ist exemplarisch der Grundaufbau einer Schaltung 41 zur Steuerung der Positionierung der Einzelspiegel 23, insbesondere mindestens eines der Einzelspiegel 23, dargestellt. Eine PWM-Steuereinrichtung 65 ist in der Figur 6 nur schematisch dargestellt. Mit dem in der Schaltung 41 dargestellten Grundaufbau ist sowohl eine Aktuierung des Einzelspiegels 23 mit Hilfe der Aktuatorelektrode 24 als auch eine Sensierung dessen Position mit Hilfe der Sensorelektrode 34 möglich. Die Begriffe Aktuatorelektrode und Sensorelektrode dienen hierbei lediglich zur Unterscheidung der Funktion. Die Aktuatorelektrode 24 und die Sensorelektrode 34 sind als ein und dieselbe Elektrode ausgebildet. Sie sind insbesondere kapazitiv ausgebildet. Die Aktuierungs- und/oder Messsignale werden zwischen den in der Schaltung 41 mit A und B bezeichneten Punkten angelegt bzw. gemessen. Die Punkte A und B sind exemplarisch auch in den Figuren 2 bis 5 dargestellt. Die Punkte A, B bilden eine Schnittstelle zwischen der Schaltung 41 und dem Einzelspiegel 23. Der Punkt B kann hierbei dem Aktuatorstift 22 entsprechen bzw. mit diesem kurzgeschlossen sein.

Als Aktuierungssignal ($V_{HVdriver}$) dient ein Signal, welches mittels einer Spannungsversorgung, insbesondere in Form einer Hochspannungs-Stufe 42 (HV driver) erzeugt wird. Das Aktivierungssignal $V_{HVdriver}$ hat eine Amplitude im Bereich von 10 V bis 1000 V, insbesondere im Bereich von 30 V bis 600 V, insbesondere im Bereich 50 V bis 200 V.

Die Ansteuerung der Aktuatorelektrode 24 und Messung der Positionierung des Einzelspiegels 23 mittels der Sensorelektrode 34 erfolgt durch ein Schalten eines Schalters 43. Für das Schalten des Schalters 43 ist eine definierte Abfolge vorgesehen. Das Aufladen der Aktuatorelektrode 24, d. h. der Aktuator-Kapazität, und das Sensieren der Sensorelektrode 34, d. h. derselben Kapazität, erfolgt somit gemäß der vorgegebenen Schaltsequenz, d. h. nacheinander. Die Abfolge Aufladen-Sensieren erfolgt jedoch sehr schnell im Vergleich zur Regelbandbreite der Steuereinrichtung 27 und im Vergleich zu den mechanischen Zeitkonstanten der Einzelspiegel 23. Die Schaltfrequenz liegt insbesondere mindestens zwei Dekaden oberhalb der kleinsten Resonanzfrequenz des Einzelspiegels. Die Schaltfrequenz liegt insbesondere im Bereich von kHz. Sie ist insbesondere größer als 10 kHz, insbesondere größer als 20 kHz, insbesondere größer als 50 kHz. Die Zeit, in welcher die Aktuatorelektrode 24 zur Messung der Kapazität nicht auf die Spannung $V_{HVdriver}$ aufgeladen ist, ist insbesondere so kurz, dass dies im Wesentlichen keinen Einfluss auf die mittlere Aktuierungskraft hat. Sie ist insbesondere kürzer als 1 ms, insbesondere kürzer als 0,3 ms, insbesondere kürzer als 0,1 ms, insbesondere kürzer als 0,03 ms.

Die Ansteuerung der Aktuatorelektrode 24 wird insbesondere mittels der PWM-Steuereinrichtung 65 gesteuert.

In der Schaltung 41 wird die Kapazität der Aktuator- bzw. Sensorelektrode 24, 34 als $C_{sens}$ bezeichnet.

Die in der Abbildung 7 dargestellte Schaltung 41 ist an mindestens eine Elektrode 24, 34 angebunden. Sie kann an mehrere Elektroden 24, 34, insbesondere mindestens zwei, insbesondere mindestens drei, insbesondere mindestens vier, insbesondere mindestens acht, insbesondere mindestens sechszehn, insbesondere mindestens zweiunddreißig Elektroden 24, 34 angebunden sein. Dies ermöglicht eine vollständige Erfassung der Kippwinkel- bzw. Positionsinformation eines oder mehrerer Einzelspiegel 23.

Die Schaltsequenz des Schalters 43 ($SW_{sample-\mu mirror}$) ist derartig gesteuert, dass die Kapazität $C_{sens}$ mit dem größten zeitlichen Anteil auf $V_{HVdriver}$ aufgeladen ist. Die Steuerung erfolgt insbesondere mittels der PWM-Steuereinrichtung 65. Das Tastverhältnis zwischen Aktuierungs- und Messdauer beträgt insbesondere mindestens 1 : 1, insbesondere mindestens 10 : 1, insbesondere mindestens 100 : 1.

Die Messzyklen sind mit anderen Worten kürzer als die Aktuierungszyklen. Sie sind insbesondere so kurz, dass die Aktuierung hierdurch im Wesentlichen nicht beeinflusst wird. Hierunter sei insbesondere verstanden, dass die durchschnittliche Aktuierungskraft gemittelt über einen Schaltzyklus um höchstens 10%, insbesondere höchstens 5%, insbesondere höchstens 1 % von der Aktuierungskraft, welche durch Anlegen von $V_{HVdriver}$ an $C_{sens}$ erreichbar ist, abweicht.

Zur Aktuierung des Einzelspiegels 23 wird der Schalter 43 in die Stellung p1 gebracht. In dieser Stellung wird $C_{sens}$ auf $V_{HVdriver}$ aufgeladen.

Während aktuiert wird, kann eine Referenzmessung (Auto-Zeroing) durchgeführt werden. Hierzu wird eine Kapazität 49 ($C_{AZ}$) auf eine Spannung $V_{AZ}$ aufgeladen. Zur Aufladung der Kapazität 49 wird diese durch Schließen eines Schalters 47 ($SW_{AZ}$) mit einer nicht näher dargestellten Spannungsquelle verbunden. Anschließend wird der Schalter 47 geöffnet. Die auf der Kapazität 49 verbleibende Ladung ist dann proportional zur Kapazität $C_{AZ}$. Die Kapazität 49 wird sodann über eine Stromquelle oder Stromsenke entladen. Dies erfolgt durch Schließen eines Schalters 48 ($SW_{discharge-CAZ}$). Die Spannung über der Kapazität 49 klingt dann linear ab, da die Entladung mit konstantem Strom, $I = dQ/dt$ erfolgt. Über einen Zähler 45, insbesondere mit konstantem Takt, kann die Entladezeit gemessen werden. Hierbei wird insbesondere die Zeit gemessen, bis die Kapazität 49 zu mindestens 90%, insbesondere vollständig entladen ist. Der Zähler 45 wird gestartet, wenn der Schalter 48 geschlossen wird. Der Zähler 45 wird gestoppt, wenn die Kapazität 49 zu mindestens 90%, insbesondere vollständig entladen ist. Die Zählung kann mit Hilfe eines Komparators 44 (Compl) durchgeführt werden. Im Weiteren sei angenommen, dass der Zählerstand des Zählers 45 nach der Entladung der Kapazität 49 beim Auto-Zeroing auf einem Wert $Count_{AZ}$ sei. Der Wert $Count_{AZ}$ wird in einem ersten Speicher 46 (Register 0) abgelegt.

Im Folgenden wird der Sensierungs-Vorgang beschrieben. Im Ausgangszustand ist der Schalter 43 in der Stellung p1. Der Schalter 47 ist geschlossen. Der Schalter 48 ist geöffnet. Zunächst wird die Kapazität $C_{sens}$ der Elektrode 34 entladen. Hierzu wird der Schalter 43 in die Stellung p3 gebracht.

Im nächsten Schritt wird die Kapazität 49 von der Referenzspannung $V_{AZ}$ getrennt. Hierzu wird der Schalter 47 geöffnet. Auf der Kapazität 49 bleibt die Ladung $Q_{AZ} = C_{AZ} \cdot V_{AZ}$, da die Kapazität 49 auf der Spannung $V_{AZ}$ geladen bleibt. Der Schritt der Öffnung des Schalters 47 kann auch kurz vor dem Entladen von $C_{sens}$ erfolgen oder gleichzeitig mit der Überführung des Schalters 41 in die Stellung p3.

Im folgenden Schritt wird die Kapazität $C_{sens}$ der Elektrode 34 mit der Kapazität 49 verbunden. Hierzu wird der Schalter 43 in die Stellung p2 gebracht. Dadurch findet ein Ladungsausgleich zwischen der Kapazität $C_{sens}$ der Sensorelektrode 34 und der auf die Spannung $V_{AZ}$ aufgeladenen Kapazität 49 statt. Der Ladungsausgleich ist beendet, wenn auf der Kapazität 49 die Spannung $U_{Start} = \dfrac{C_{AZ}}{C_{AZ} + C_{sens}} \cdot V_{AZ}$ verbleibt. Die Ladung auf der Kapazität 49 verringert sich somit durch den Ladungsausgleich. Die Ladungsmenge, die auf der Kapazität 49 verbleibt, hängt vom aktuellen Wert der zu messenden Kapazität $C_{sens}$ der Sensorelektrode 34 ab. Die verbleibende Ladung auf der Kapazität 49 wird gemessen, indem der Schalter 43 wieder in Stellung p1 gebracht wird. In dieser Stellung wird die Kapazität $C_{sens}$ der Aktuatorelektrode 24 wieder geladen. Zur Messung der verbleibenden Ladung auf der Kapazität 49 wird diese wie bei der Referenzmessung über die gleiche Stromquelle bzw. Stromsenke entladen. Die Entladung wird gestartet, indem der Schalter 48 geschlossen wird. In diesem Moment wird auch der Zähler 45 gestartet. Der Zähler 45 wird gestoppt, wenn die Kapazität 49 zu mindestens 90% entladen ist. Der Zähler 45 wird wiederum über den Komparator 44 getriggert. Der resultierende Zählerstand wird mit $Count_{Mess}$ bezeichnet. Er wird in einem zweiten Speicher 50 (Register 1) abgelegt.

Theoretisch dauern die Vorgänge zum vollständigen Ladungsausgleich unendlich lange. Die Zeitkonstanten sind jedoch so ausgelegt, dass die Ausgleichsvorgänge ausreichend schnell, insbesondere innerhalb von weniger als 0,1 ms, insbesondere weniger als 0,01 ms abgeschlossen sind. Die Schaltung ist insbesondere schneller als die Regelbandbreite der Steuereinrichtung 27. Sie ist insbesondere schneller als die mechanischen Zeitkonstanten des Einzelspiegels 23, insbesondere dessen Resonanzfrequenz. Für die praktische Anwendung kann ein Vorgang nach spätestens fünf Zeitkonstanten, insbesondere nach spätestens zehn Zeitkonstanten, als abgeschlossen gelten.

Unter Annahme einer konstanten Spannung $V_{AZ}$ kann die Kapazität $C_{sens}$ der Sensorelektrode 34 mit Hilfe eines digitalen Elements 51 als

$$C_{sens} = C_{AZ} \cdot \left( \frac{Count_{AZ}}{Count_{meas}} - 1 \right)$$

In der Fig. 6 ist schematisch ein analoger Teil 52 und ein digitaler Teil 53 der Schaltung 41 gekennzeichnet. Zum Kern des analogen Teils 5 gehören insbesondere die Schalter 43, 47 und 48 sowie die Kapazität $C_{sens}$ der Sensorelektrode 34 und die Kapazität 49 und der Komparator 44. Zum erweiterten analogen Teil 52 kann man auch die Hochspannungsstufe 42 zählen.

Der Komparator 44 bildet eine Schnittstelle vom analogen Teil 52 zum digitalen Teil 53.

Der analoge Teil ist einerseits über eine Schnittstelle an den Punkten A, B mit der Kapazität $C_{sens}$ der Sensorelektrode 34 verbunden. Er ist andererseits über einen Ausgang des Komparators 44 und den Ansteuerungssignalen für die Schalter mit dem digitalen Teil 53 verbunden.

Erfindungsgemäß kann vorgesehen sein, für mehrere Elektroden 24, 34, insbesondere für mindestens zwei, insbesondere mindestens drei, insbesondere mindestens vier Elektroden 24, 34 je Einzelspiegel 23 ein gemeinsames analoges Teil 52 zu verwenden. Das gemeinsame analoge Teil 52 kann mit einem digitalen Teil 53 in signalübertragender Weise verbunden sein, es kann auch mit mehreren digitalen Teilen $53_i$ in signalübertragender Weise verbunden sein. Durch Verwendung eines einzigen analogen Teils 52 für mehrere Elektroden 24, 34 kann die insgesamt für die Schaltung 41 benötigte Fläche auf dem ASIC 28 verringert werden.

In diesem Fall ist der Schalter 43 derart ausgebildet, dass er jede der entsprechenden Elektroden 24, 34 mit einer zugehörigen Hochspannungsstufe 42 (Schalterstellung p1), mit der Messschaltung (Schalterstellung p2) oder mit 0 V zur Entladung (Schalterstellung p3) verbunden werden kann.

Eine zweite Schalteinheit verbindet dann eine auswählbare Kapazität $C_{sens,i}$ mit der Messschaltung, welche die Kapazität 49 aufweist.

Die zeitliche Sequenzierung muss bei diesem Ausführungsbeispiel sehr genau ausgelegt werden. Die Vorteile der Platzersparnis auf dem ASIC 28 überwiegen jedoch.

In einer weiteren, besonders vorteilhaften Ausführungsform ist für jeden Einzelspiegel 23 nur eine einzige Treiberschaltung, insbesondere eine einzige Hochspannungsstufe 42, zur Erzeugung der Ansteuerspannung $V_{HVdriver}$ vorgesehen. Dies führt zu einer wesentlichen Platzersparnis. Bei diesem Ausführungsbeispiel ist vorgesehen, die effektive Spannung an den Aktuatorelektroden 24 über ein Pulsweitenmodulations-Schema (PWM-Schema) zu erzeugen. Dies ist auf einfache Weise möglich, da der analoge Teil 52 ohnehin eine komplexe Sequenzierung für die Ansteuerung der Schalter 43, 47, 48 aufweist. Bei diesem Ausführungsbeispiel werden sämtliche Aktuatorelektroden 24 eines Einzelspiegels 23 mit einer gemeinsamen Spannung $V_{HVdriver}$ beaufschlagt. Die Effektivspannung und damit die Akuierungskraft wird über das Tastverhältnis an den Schaltern eingestellt.

Bei diesem Ausführungsbeispiel können auch Digital-Analog-Wandler (DA-Wandler) eingespart werden, da die Wandlung implizit über die PWM-Erzeugung erfolgt. Die PWM-Signale müssen nicht gefiltert werden. Eine Filterung kann implizit durch die Massenträgheit des mechanischen Systems des Einzelspiegels 23 erfolgen.

Bei diesem Ausführungsbeispiel kann insbesondere vorgesehen sein, auf verschiedenen Kanälen extra Clock-Jitter einzuprägen, um synchrones Schalten und damit gleichzeitigen Stromfluss von sehr vielen Kanälen zu vermeiden. Hierdurch wird die elektromagnetische Verträglichkeit sichergestellt. Clock Jitter bedeutet, dass auf die Taktungen der einzelnen Schalter in verschiedenen Einheiten der Schaltung absichtlich kleine Schwankungen, insbesondere im Bereich von maximal 1 % der Taktrate,aufgeprägt werden, um Schaltflanken zeitlich mehr zu verteilen. Die Schwankungen müssen dann von Einheit zu Einheit möglichst unterschiedlich bzw. unkorreliert sein.

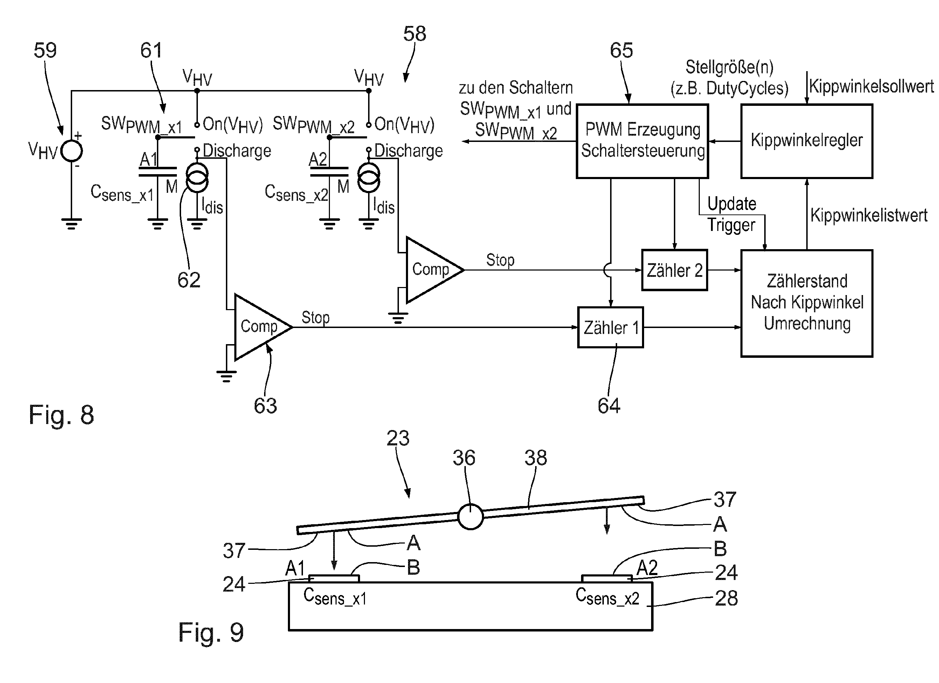

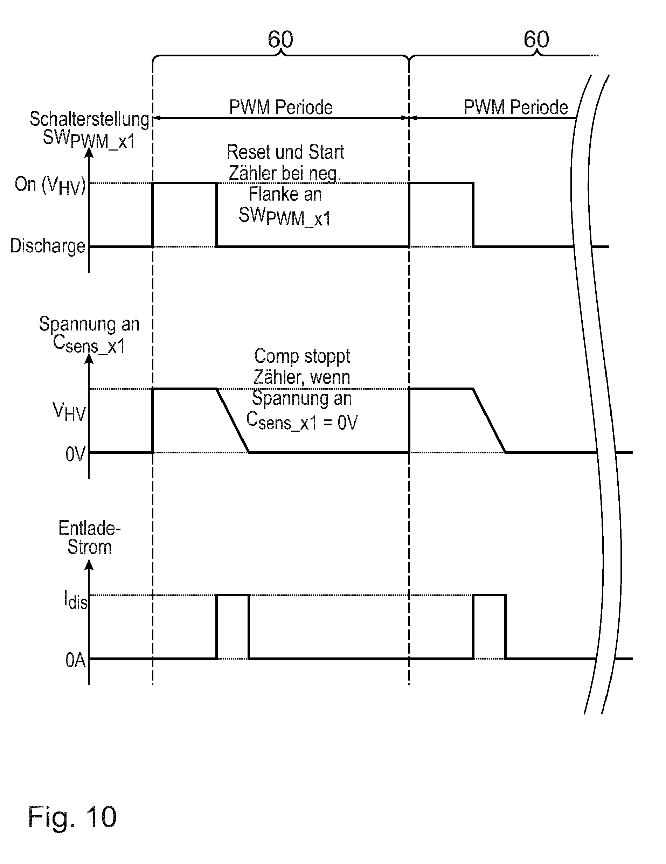

Im Folgenden wird unter Bezugnahme auf die Fig. 8 bis 10 ein weiteres Ausführungsbeispiel beschrieben. Fig. 8 zeigt schematisch den Grundaufbau einer alternativen Schaltung 58 der Steuereinrichtung 27. Fig. 9 zeigt schematisch die Anbindung an den Einzelspiegel 23. Fig. 10 zeigt schematisch die zeitliche Abfolge der Ansteuerung. Zur einfacheren Zuordnung sind einander entsprechende Punkte in den Fig. 8 und 9 mit entsprechenden Bezeichnungen gekennzeichnet.

Die Schaltung 58 hat wesentliche Vorteile sowohl im Hinblick auf die Aktuierung als auch auf die Sensierung des Einzelspiegels 23. Da sie ohne die Referenzmessung der Schaltung 41 mit den dafür benötigten Bauteilen, insbesondere der Kapazität 49 und der Spannungsquelle zur Erzeugung der Spannung $V_{AZ}$, auskommt, werden stets vorhandene Rauscheinflüsse dieser Bauteile vermieden.

Die Grundidee der Schaltung 58 ist, dass die Spiegel 23 nicht an separate, analoge Hochspannungsstufen 42 angeschlossen sind, sondern dass die Ansteuerung, d. h. die Aktuierung, über Pulsweitenmodulation (PWM), insbesondere mittels der hierfür vorgesehenen PWM-Steuereinrichtung 65, erfolgt. Die Kraftwirkung der Aktuatorelektroden 24 wird hierbei durch das Tastverhältnis bestimmt, mit welchem zwischen einer Aufladung auf eine Hochspannung $V_{HV}$ und Entladung der jeweiligen Elektroden 24 hin- und hergeschaltet wird.

Bei diesem Ausführungsbeispiel teilen sich sämtliche Spiegel 23 des optischen Bauelements 25, d. h. sämtliche Einzelspiegel 23 des Mikrospiegel-Arrays, eine gemeinsame Spannungsquelle 59 zur Erzeugung der Spannung $V_{HV}$. $V_{HV}$ liegt insbesondere im Bereich von 10 V bis 1000 V, insbesondere im Bereich von 30 V bis 600 V, insbesondere im Bereich von 50 V bis 200 V.

In Fig. 9 ist schematisch dargestellt, wie die Schaltung 58 gemäß Fig. 8 an einen Einzelspiegel 23 angebunden sein kann. Der Punkt M bezeichnet die Oberfläche des Einzelspiegels 23. Diese ist, wie auch aus Fig. 10 ersichtlich ist, geerdet, d. h. mit Masse (englisch: ground, GND) verbunden. Der Punkt M ist in der Darstellung der Schaltung 58 gemäß Fig. 8 zweifach dargestellt. Er bezeichnet jedoch im Prinzip dieselbe Elektrode. Die Punkte $A_1$ und $A_2$ stellen die jeweilige Gegenelektrode der Aktuator- und Sensorelektrode 24, 34 dar.

In der Fig. 10 ist schematisch die zeitliche Abfolge der Steuerung der Positionierung des Einzelspiegels 23 mit Hilfe der Schaltung 58 gemäß Fig. 8 dargestellt. Dargestellt sind in der Fig. 10 zwei aufeinanderfolgende PWM-Zyklen 60.

Der Einfachheit halber ist repräsentativ die zeitliche Abfolge der Signale an lediglich einer einzigen Kapazität einer einzigen Aktuator- und Sensorelektrode 24, 34 dargestellt. In der obersten Zeile ist die Schalterstellung eines Schalters 61 ($SW_{PWM\,x1}$) dargestellt. Mittels des Schalters 61 ist die Aktuator- und Sensorelektrode 24, 34 einerseits mit der gemeinsamen Spannungsquelle 59 verbindbar, andererseits zur Endladung mit einer Stromsenke 62 ($I_{dis}$) sowie einem Komparator 63 (Comp) verbindbar.

Die PWM-Zyklen 60 weisen ein Tastverhältnis von etwa 25% auf.

In der mittleren Zeile der Fig. 10 ist der Verlauf der Spannung an der Kapazität $C_{Sens\_x1}$ der Aktuator- und Sensorelektrode 24, 34 dargestellt. Auch wenn der Ladevorgang in der Praxis aufgrund der Kapazität und eines stets vorhandenen parasitären Widerstands nicht unendlich kurz ist, ist er in der Fig. 10 als quasi-instantan dargestellt. Der Ladevorgang ist insbesondere sehr schnell im Vergleich zur Gesamtdauer des PWM-Zyklus 60. Er dauert insbesondere höchstens 50 %, insbesondere höchstens 5 %, insbesondere höchstens 1 %, insbesondere höchstens 0,1 %, insbesondere höchstens 0,01 % der Dauer des PWM-Zyklus 60.

In der vierten Zeile ist schematisch der Entladestrom bei der Entladung der Kapazität der Aktuator- und Sensorelektrode 24, 34 über die Stromsenke 62 dargestellt.

Mit dem Umschalten des Schalters 61 aus einer ersten Stellung, in welcher er mit der gemeinsamen Spannungsquelle 59 verbunden ist, in eine zweite Stellung, in welcher er mit der Stromsenke 62 verbunden ist, wird ein Zähler 64 (Zähler 1) zurückgesetzt und gestartet.

Sobald die Spannung an der Kapazität $C_{Sens}$ der Aktuator- und Sensorelektrode 24, 34 beim Entladevorgang unter einen bestimmten, vorgegebenen Wert abgefallen ist, d. h. sobald die Kapazität ein bestimmtes Entladeniveau erreicht hat, insbesondere sobald die Spannung an dieser Kapazität im Wesentlichen 0 V beträgt, wird der Zähler 64 vom Komparator 63 gestoppt.

Die Schaltgeschwindigkeit, insbesondere die Grundfrequenz der PWM-Signale ist mindestens zehnmal, insbesondere mindestens zwanzigmal, insbesondere mindestens fünfzigmal so hoch wie eine Kippresonanzfrequenz, insbesondere die höchste maßgebende Kippresonanzfrequenz der Einzelspiegel 23. Die Mechanik der Einzelspiegel 23 wirkt dann als Tiefpassfilter. Über die Tastverhältnisse der PWM-Signale erfolgt somit eine quasi-analoge Ansteuerung.

Beim Einsatz in EUV-Systemen, insbesondere in der Beleuchtungsoptik 4, für die Projektionsbelichtungsanlage 1 für die EUV-Lithografie sollen insbesondere Schwingungen, insbesondere Eigenschwingungen, im Resonanzbereich der Einzelspiegel 23 gedämpft werden. Die Regelbandbreite der Steuereinrichtung 27 liegt von daher vorzugsweise deutlich oberhalb der Resonanzfrequenz. Sie liegt insbesondere mindestens einer Dekade, insbesondere mindestens zwei Dekaden oberhalb der Resonanzfrequenz. Sie ist vorzugsweise mindestens zweimal, insbesondere mindestens dreimal, insbesondere mindestens fünfmal, insbesondere mindestens zehnmal so groß wie die Resonanzfrequenz.

Für die Steuerung der Positionierung der Einzelspiegel 23 ist es vorteilhaft, wenn der Grundtakt der PWM-Signale mindestens zehnmal, insbesondere mindestens dreißigmal, insbesondere mindestens fünfzigmal, insbesondere mindestens einhundertmal, insbesondere mindestens dreihundertmal so hoch ist wie die höchste maßgebende Resonanzfrequenz der Einzelspiegel 23.

Bei einem exemplarischen System liegt die Resonanzfrequenz der Einzelspiegel 23 im Bereich von 400 Hz, die Regelbandbreite der Steuereinrichtung 27 im Bereich von 4000 Hz und die Grundfrequenz der PWM-Signale im Bereich von 40000 Hz.

Das Tastverhältnis liegt insbesondere im Bereich von 10% bis 90%. Es kann insbesondere mindestens 20%, insbesondere mindestens 30%, insbesondere mindestens 50% betragen. Da zur Erfassung der Positionierung des Einzelspiegels 23 eine Entladung der Kapazität $C_{sens}$ der Aktuator- und Sensorelektrode 24, 34 erforderlich ist, und diese Messung in einem Entladezeitraum mit einer von null verschiedenen Dauer stattfindet, ist ein Tastverhältnis von 100% nie ganz zu erreichen. Bei einem Tastverhältnis von 90% bleiben 10% der Dauer des PWM-Zyklus 60 für die Kapazitätsmessung. Im Falle einer PWM-Grundfrequenz von 40000 Hz entspricht dies einer Dauer von 2,5 $\mu$sec.

Der Zähler 64 kann eine Taktrate von 400 MHz aufweisen. In diesem Fall ist eine Messung der Kapazität $C_{Sens}$ der Aktuator- und Sensorelektrode 24, 34 mit 10 bit Auflösung möglich.

Der Zähler 64 kann auch eine andere Taktrate aufweisen. Die Taktrate des Zählers 64 beträgt insbesondere mindestens 100 MHz, insbesondere mindestens 200 MHz, insbesondere mindestens 400 MHz. Sie kann auch mindestens 600 MHz, mindestens 800 MHz oder mindestens 1 GHz betragen.

Um Platz auf dem ASIC 28 einzusparen, können Widerstände in der Schaltung 58 durch Stromquellen und/oder sogenannte Strombegrenzer (Slew-Rate-Limiter) eingesetzt werden. Slew-Rate-Limiter begrenzen die Anstiegsflanken, d.h. die zeitliche Ableitung eines Signals bzw. einer physikalischen Größen wie z.B. Strom.

Durch Einsatz verschiedener Grundtakte und Clock-Jitter kann die elektromagnetische Verträglichkeit der Schaltung 58 verbessert werden. Vorzugsweise weisen die Schaltungen 58 der Steuereinrichtungen 27 für unterschiedliche Einzelspiegel 23 zumindest teilweise unterschiedliche Grundtakte auf.

Vorteilhafterweise wird ein sogenanntes Center-Aligned PWM-Verfahren eingesetzt.

Die Steuerung der Positionierung der Einzelspiegel 23 mittels einer PWM-Ansteuerung/Messung, insbesondere mittels der Schaltung 58 gemäß Fig. 8, hat u. a. den Vorteil, dass kein DA-Wandler erforderlich ist. Die Steuerung weist außerdem einen hohen digitalen Anteil auf. Dies führt dazu, dass sie sehr platzsparend auf einem ASIC 28 realisierbar ist. Ein weiterer Vorteil besteht darin, dass keine Referenzkapazität erforderlich ist. Hierdurch wird eine Quelle für Rauscheinflüsse und dadurch verursachte Messungenauigkeiten eliminiert.

**Patentansprüche**

1. Einrichtung (27) zur Steuerung der Positionierung mindestens eines verlagerbaren Einzelspiegels (23) umfassend

   a. eine Aktuator-Einrichtung mit mindestens einer Aktuator-Elektrode (24),
   b. eine Sensor-Einrichtung mit mindestens einer Sensor-Elektrode (34) und
   c. wobei mindestens eine Aktuator-Elektrode (24) auch als Sensor-Elektrode (34) dient,
   d. **dadurch gekennzeichnet, dass** die Ansteuerung der Einzelspiegel (23) über eine Pulsweitenmodulation erfolgt.

2. Einrichtung (27) gemäß Anspruch 1, **dadurch gekennzeichnet, dass** zur Steuerung mehrerer Elektroden (24, 34) eine gemeinsame analoge Schaltung (52) vorgesehen ist.

3. Einrichtung (27) gemäß einem der vorhergehenden Ansprüche, **gekennzeichnet durch** ein Tastverhältnis zwischen Aktuierungs- und Messdauer von mindestens 1:1.

4. Einrichtung (27) gemäß einem der vorhergehenden Ansprüche, **dadurch gekennzeichnet, dass** eine einzige Spannungsversorgung (42; 59) je Einzelspiegel (23) vorgesehen ist.

5. Einrichtung (27) gemäß einem der vorhergehenden Ansprüche, **dadurch gekennzeichnet, dass** eine einzige Spannungsversorgung (42; 59) für sämtliche Einzelspiegel (23) in einem Einzelspiegel-Array vorgesehen ist.

6. Optische Baugruppe (13, 14) umfassend

   a. eine Vielzahl von verlagerbaren Einzelspiegeln (23)
   b. eine Steuereinrichtung (27) gemäß einem der Ansprüche 1 bis 5.

7. Beleuchtungsoptik (4) für eine Projektionsbelichtungsanlage (1) für die Mikrolithographie umfassend mindestens eine Baugruppe gemäß Anspruch 6.

8. Beleuchtungssystem (2) für eine Projektionsbelichtungsanlage (1) für die Mikrolithographie umfassend eine Beleuchtungsoptik (4) gemäß Anspruch 7 und eine Strahlungsquelle (3) zur Erzeugung von Beleuchtungsstrahlung (10).

9. Projektionsbelichtungsanlage (1) für die Mikrolithographie umfassend eine Beleuchtungsoptik (4) gemäß Anspruch 7 und eine Projektionsoptik (7).

10. Verfahren zur Positionierung von Einzelspiegeln (23) einer optischen Baugruppe gemäß Anspruch 6, **gekennzeichnet, durch** einen Mess- und Aktuierungszyklus mit aufeinanderfolgenden Mess- und Aktuierungs-Schritten, wobei die Ansteuerung der Einzelspiegel (23) über ein Pulsweitenmodulationsschema erfolgt.

11. Verfahren gemäß Anspruch 10, **dadurch gekennzeichnet, dass** der Mess- und Aktuierungszyklus eine Zyklusdauer aufweist, welche kürzer ist als eine Zeitkonstante entsprechend der Regelbandbreite der Steuereinrichtung (27) und/oder die kürzeste Zeitkonstante des Einzelspiegels (23).

12. Verfahren zur Herstellung eines mikro- oder nanostrukturierten Bauelements umfassend die folgenden Schritte:

   - Bereitstellen eines Substrats, auf das zumindest teilweise eine Schicht aus einem lichtempfindlichen Material aufgebracht ist,
   - Bereitstellen eines Retikels, das abzubildende Strukturen aufweist,
   - Bereitstellen einer Projektionsbelichtungsanlage (1) gemäß Anspruch 9,
   - Projizieren wenigstens eines Teils des Retikels auf einen Bereich der lichtempfindlichen Schicht des Substrats mit Hilfe der Projektionsbelichtungsanlage (1).

Fig. 1

EP 2 687 906 A2

Fig. 2

Fig. 3

Fig. 4

Fig. 5

Fig. 6

52

HV Treiber

42

$V_{HVdriver}$

Wandler

$C_{sens}$

24, 34

A

B

$SW_{sample-\mu mirror}$

p1

p2

p3

43

$V_{AZ}$

47

$SW_{AZ}$

$C_{AZ}$

$VSS = 0V$

49

$SW_{discharge-CAZ}$

$I_{discharge}$

48

Comp1

44

Lese Zählerwert

Fig. 7

Fig. 8

Fig. 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2010049076 A2
- DE 102012202501
- DE 102012218219
- EP 1225481 A
- DE 102011006100